(19) Europäisches Patentamt
European Patent Office
Office européen des brevets

(11) **EP 3 184 962 A1**

(12) **EUROPEAN PATENT APPLICATION**

(43) Date of publication:
**28.06.2017 Bulletin 2017/26**

(51) Int Cl.:
**G01C 19/5733** (2012.01)  **B81B 5/00** (2006.01)
**G01P 15/125** (2006.01)

(21) Application number: **16198839.9**

(22) Date of filing: **15.11.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **16.11.2015 US 201514942506**

(71) Applicant: **NXP USA, Inc.**
**Austin TX 78735 (US)**

(72) Inventor: **Shao, Peng**
**5656 AG Eindhoven (NL)**

(74) Representative: **Freescale law department - EMEA patent ops**
**NXP Semiconductors,**
**134 avenue du Général Eisenhower**
**BP 72329**
**31023 Toulouse Cedex 1 (FR)**

(54) **MEMS DEVICE WITH CAPACITANCE ENHANCEMENT ON QUADRATURE COMPENSATION ELECTRODE**

(57)    A MEMS device includes a mass system capable of undergoing oscillatory drive motion along a drive axis and oscillatory sense motion along a sense axis perpendicular to the drive axis. A quadrature correction unit includes a fixed electrode and a movable electrode coupled to the movable mass system, each being lengthwise oriented along the drive axis. The movable electrode is spaced apart from the fixed electrode by a gap having an initial width. At least one of the fixed and movable electrodes includes an extrusion region extending toward the other of the fixed and movable electrodes. The movable electrode undergoes oscillatory motion with the mass system such that the extrusion region is periodically spaced apart from the other of the fixed and movable electrodes by a gap exhibiting a second width that is less than the first width thereby enabling capacitance enhancement between the electrodes.

FIG . 3

**Description**

**TECHNICAL FIELD OF THE INVENTION**

The present invention relates generally to microelectromechanical systems (MEMS) devices. More specifically, the present invention relates to capacitance enhancement for a MEMS device, such as an angular rate sensor.

**BACKGROUND OF THE INVENTION**

Microelectromechanical systems (MEMS) technology has achieved wide popularity in recent years, as it provides a way to make very small mechanical structures and integrate these structures with electrical devices on a single substrate using conventional batch semiconductor processing techniques. One common application of MEMS is the design and manufacture of sensor devices. MEMS sensor devices are widely used in applications such as automotive, inertial guidance systems, household appliances, game devices, protection systems for a variety of devices, and many other industrial, scientific, and engineering systems. One example of a MEMS sensor is a MEMS angular rate sensor. Alternatively referred to as a "gyroscope", "gyrometer," "vibratory rate gyroscopes," "gyroscope sensor," or "yaw rate sensor," an angular rate sensor senses angular speed or velocity around one or more axes.

In vibratory angular rate sensors, an inherent problem is the existence of undesirable interference signals, referred to as quadrature motion or quadrature error. Quadrature motion is defined as the direct coupling of the drive mode displacement to the sense mode of the angular rate sensor. Typically, quadrature motion occurs in vibrating angular rate sensors due to manufacturing imperfections that permit the sense mass to oscillate relative the sense axis in response to the drive mode displacement in an orthogonal direction. This oscillation can be confused with Coriolis acceleration and subsequently the rotation rate. Quadrature motion can result in offset error, reduced dynamic range, and increased noise for the device. A large quadrature error can even cause a device to rail so that the sense mass comes into contact with conductive electrodes potentially resulting in collision-related damage, such as a short. Accordingly, the introduction of MEMS angular rate sensors into the high-precision, low power consumption market has been problematic due at least in part to error sources, such as quadrature motion.

**BRIEF DESCRIPTION OF THE DRAWINGS**

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.

FIG. 1 shows, in a simplified and representative form, a top view of a prior art angular rate sensor;
FIG. 2 shows a top view of an angular rate sensor in accordance with an embodiment;
FIG. 3 shows an enlarged top view of a fixed electrode and a movable electrode of the angular rate sensor of FIG. 2 in a first position relative to one another;
FIG. 4 shows an enlarged top view of a fixed electrode and a movable electrode of the angular rate sensor of FIG. 2 in a second position relative to one another;
FIG. 5 shows a chart of a time varying quadrature compensation force resulting from the implementation of the fixed and movable electrodes within the angular rate sensor of FIG. 2; and
FIG. 6 shows a generalized block diagram of a sensor package that includes the angular rate sensor of FIG. 2 in communication with a control circuit.

**DETAILED DESCRIPTION**

Embodiments disclosed herein entail microelectromechanical systems (MEMS) devices, such as angular rate sensors, in which a quadrature compensation unit is implemented to null or otherwise compensate for quadrature motion. The quadrature compensation unit includes pairs of fixed and movable electrodes, and the fixed and movable electrodes include extrusion regions extending toward one another. When the movable electrodes undergo oscillatory motion, the extrusion regions are periodically positioned between each pair of fixed and movable electrodes to effectively reduce a width of a gap between the movable and fixed electrodes. A force needed to compensate for the quadrature motion depends upon the width of the gap between movable and fixed electrodes, the voltage applied, and the total overlap area of the fixed and movable electrodes. The reduced width of the gap provides capacitance enhancement so as to reduce the voltage and the number of fixed and movable electrodes needed to effectively generate the quadrature compensation force.

The instant disclosure is provided to further explain in an enabling fashion the best modes, at the time of the application, of making and using various embodiments in accordance with the present invention. The disclosure is further offered to enhance an understanding and appreciation for the inventive principles and advantages thereof, rather than to limit in any manner the invention. The invention is defined solely by the appended claims including any amendments made during the pendency of this application and all equivalents of those claims as issued.

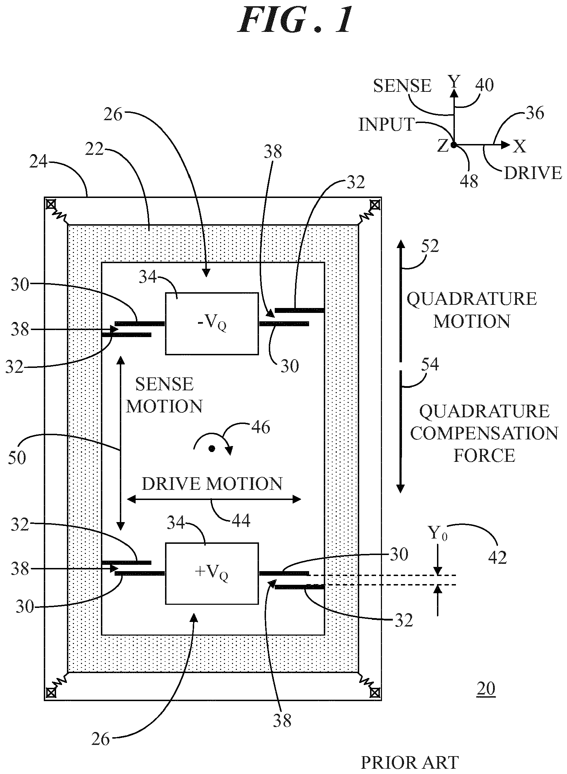

Referring to FIG. 1, FIG. 1 shows, in a simplified and representative form, a top view of a prior art angular rate sensor 20. In general, angular rate sensor 20 includes a movable mass system 22 flexibly coupled to a substrate 24 and a quadrature compensation unit 26. Quadrature compensation unit 26 includes pairs of fixed and movable electrodes 30, 32. More particularly, fixed electrode 30 of each pair extends from an anchor structure 34 coupled to substrate 24 and movable electrode 32 of each pair is coupled to and extends from movable mass system 22. Thus, movable electrode 32 is movable relative to fixed electrode 30. In the illustrated example, fixed and movable electrodes 30, 32 are lengthwise oriented in a first direction corresponding to an X-axis 36 in a three-dimensional coordinate system. Additionally, movable electrode 32 is laterally spaced apart from fixed electrode 30 by a gap 38 in a second direction corresponding to a Y-axis 40 that is perpendicular to X-axis 36. Gap 38 exhibits a width 42, labeled Yo.

To operate angular rate sensor 20, a drive system (not shown for simplicity of illustration) in communication with movable mass system 22 enables oscillatory drive motion, as represented by a bi-directional arrow 44, of movable mass system 22 substantially parallel to a drive axis, which in this example is X-axis 36. Thus, X-axis 36 is referred to herein as drive axis 36. Oscillatory drive motion 44 of movable mass system 22 may be kept constant to maintain constant sensitivity of angular rate sensor 20. Additionally or alternatively, the frequency of oscillation can be locked to the mechanical resonance of movable mass system 22 to minimize drive power.

Once movable mass system 22 is put into oscillatory drive motion 44 parallel to drive axis 36, it is capable of detecting an angular rate, i.e., angular velocity as represented by a curved arrow 46, induced by angular rate sensor 20 being rotated about an axis of rotation, referred to herein as an input axis. In this example, the input axis is the Z-axis 48 in a three-dimensional coordinate system. Thus, Z-axis 48 is referred to herein as an input axis 48 in connection with angular rate sensor 20. As angular rate sensor 20 experiences angular velocity 46 about input axis 48, movable mass system 22 undergoes oscillatory sense motion, represented by a bi-directional arrow 50, substantially parallel to a sense axis, which in this example, is Y-axis 40. Thus, Y-axis 40 is referred to herein as sense axis 40 in connection with angular rate sensor 20. In particular, a Coriolis acceleration occurs relative to sense axis 40, which is perpendicular to both drive axis 36 and input axis 48. The Coriolis acceleration causes generally in-plane linear oscillatory sense motion 50 of movable mass system 22 parallel to sense axis 40. This linear oscillatory sense motion 50 has an amplitude that is proportional to angular velocity 46 of sensor 20 about input axis 48. Oscillatory sense motion 50 can be detected as changes in capacitance between fixed and movable sense electrodes of a sense system (not shown for simplicity) as known to those skilled in the art.

Movable mass system 22 is represented in greatly simplified form. It should be understood, however, that movable mass system 22 can include a great variety of shapes and configurations. For example, movable mass system 22 may include one or more drive masses suitably interconnected with one or more sense masses, where the sense mass(es) together with the drive mass(es) undergo oscillatory drive motion 44, and the sense mass(es) undergo oscillatory sense motion 50 in response to angular velocity 46. Alternatively, movable mass system 22 may include a single mass flexibly coupled to substrate 24 that can undergo oscillatory drive motion 44 and undergo oscillatory sense motion 50 in response to angular velocity 46.

As mentioned previously, movable mass system 22 may undergo quadrature motion, represented by an arrow 52. Quadrature motion 52 of movable mass system 22 can be a result of signal leakage from drive axis 36 to sense axis 40 caused by mass and spring imbalance due to manufacturing imperfections, anisoelastic coupling, and so forth. This quadrature motion 52 can result in a quadrature error signal that can be as large as thousands of degrees per second and can be ninety degrees out of phase with the Coriolis acceleration. Demodulation can eliminate some of the error component resulting from the quadrature motion 52. However, a small phase error may still overwhelm a sense loop circuit.

Accordingly, quadrature compensation unit 26 may be implemented with angular rate sensor 20 in order to apply an electrostatic force, referred to herein as a quadrature compensation force and represented by an arrow 54, via fixed and movable electrodes 30,32 in opposite phase relation to quadrature motion 52. Quadrature compensation force 54 is applied to compensate for, or otherwise null, quadrature motion 52. The arrow representing quadrature compensation force 54 is oriented in a direction opposite to that of the arrow representing quadrature motion 52 in order to emphasize the opposite phase relation. It should be understood, however, that quadrature motion 52 is an oscillatory motion. Therefore, quadrature compensation force 54 is an oscillatory motion in opposite phase relation to the oscillatory quadrature motion 52.

A gyroscope equation of motion with off-diagonal terms is represented, as follows:

$$\begin{bmatrix} m_d & 0 \\ 0 & m_s \end{bmatrix}\begin{bmatrix} \ddot{x} \\ \ddot{y} \end{bmatrix} + \begin{bmatrix} c_x & 0 \\ 0 & c_y \end{bmatrix}\begin{bmatrix} \dot{x} \\ \dot{y} \end{bmatrix} + \begin{bmatrix} k_x & k_{xy} \\ k_{yx} & k_y \end{bmatrix}\begin{bmatrix} x \\ y \end{bmatrix} = \begin{bmatrix} F_d \\ -2m_c\Omega_z\dot{x} \end{bmatrix} \qquad (1)$$

which yields the following:

$$m_s\ddot{y} + c_y\dot{y} + k_y y = -2m_c\Omega_z\dot{x} - k_{yx}x \qquad (2)$$

In the equations presented above, $F_d$ is the drive force needed to enable oscillatory drive motion 44 of movable mass system 22, where $m_d$ is the mass of the drive mass portion of movable mass system 22, $c_x$ is the damping coefficient in the drive (x) direction, $k_x$ is the spring constant in the drive direction, $k_{xy}$ is the spring constant cross-coupling force on sense axis (y) 40 that may cause displacement along drive axis (x) 36, $\ddot{x}$ is acceleration in the drive direction, $\dot{x}$ is velocity in the drive direction, and x is the drive displacement. Additionally, $m_s$ is the mass of the sense mass portion of movable mass system 22, $c_y$ is the damping coefficient in the sense (y) direction, $k_y$ is the spring constant in the sense direction, $k_{yx}$ is the spring constant cross-coupling force on drive axis (x) 36 that may cause displacement along sense axis (y) 40, $\ddot{y}$ is acceleration in the sense direction, $\dot{y}$ is velocity in the sense direction, and y is the sense displacement.

In equation (2), the righthand side of the equation reveals that sense motion 50 is a function of $m_c$, $\Omega_z$ and $\dot{x}$, where $m_c$ is the mass of the "Coriolis mass" (i.e., the mass upon which Coriolis acceleration is being imposed upon), $\Omega_z$ is angular velocity 46 about input axis (z) 48, and $\dot{x}$ is the velocity in the drive direction. Additionally, quadrature motion 52 is a function of $k_{yx}$ and x, where $k_{yx}$ is the spring constant cross-coupling force on sense axis (y) 40 from drive axis (x) 36 and x is the drive displacement. Thus, a time varying force that is in phase with oscillatory drive motion 44 is needed to cancel quadrature motion 52, represented by $k_{yx}x$ in equation (2).

Quadrature compensation force 54 needed to cancel quadrature motion 52 can be characterized by the following equations:

$$E = \frac{1}{2}CV^2 = \frac{1}{2}\left[C_0 + N\varepsilon\frac{xh}{y}\sin(\omega_d t)\right]\left(V_{pm} - V_q\right)^2 \qquad (3)$$

and

$$F_q = -\frac{\partial E}{\partial y} \propto \varepsilon h V_{pm}\frac{NV_q}{y_o^2}x \qquad (4)$$

In the equations presented above, E is the energy of a capacitor, C is capacitance, and V is voltage. Further, Co is static capacitance, N is the total overlap area of fixed and movable electrodes 30, 32, $\varepsilon$ is permittivity of the free space, h is the structural thickness, y is the displacement along sense axis 40, $\sin(\omega_d t)$ is the drive motion, $\omega_d$ is the drive frequency, t is time, $V_{pm}$ is the voltage potential of the drive mass portion of movable mass system 22, and Vq is the voltage applied to fixed electrodes 30 of each pair of fixed and movable electrodes 30,32.

In equation (4), Fq represents quadrature compensation force 54, i.e., the electrostatic force needed to compensate for or null quadrature motion 52. Quadrature compensation force 54 is a function of the partial derivative of the energy of a capacitor and the partial derivative of the displacement along sense axis. Thus, quadrature compensation force 54 is proportional to the product of the permittivity of free space ($\varepsilon$), the structural thickness (h), the voltage potential of the drive mass portion of movable mass system 22 ($V_{pm}$), displacement along drive axis 36 (x), and a fraction in which the numerator is a product of the overlap area (N) of fixed and movable electrodes 30, 32 and the voltage applied to fixed electrodes 30 of each pair of fixed and movable electrodes 30, 32 ($V_q$) and the denominator is the square of the width 42 ($y_0$) of gap 38 between fixed and movable electrodes 30, 32.

While application of quadrature compensation force ($F_q$) 54 can suppress quadrature motion 52, this technique requires relatively a large voltage ($V_q$) and large overlap area (N) for quadrature compensation electrodes (e.g., fixed and movable electrodes 30, 32), and/or precise phase matching between the quadrature error and the electrostatic compensation force. In order to save voltage ($V_q$) and area (N), it can be readily observed from equation (4) that a relatively small width 42 ($y_0$) of gap 38 is preferred. That is, quadrature compensation force (Fq) 54 is proportional to voltage ($V_q$) and area (N). However, the net quadrature compensation force (Fq) 54 increases quadratically by decreasing width 42 of gap 38 between fixed and movable electrodes 30, 32.

Unfortunately, width 42 is limited by the minimum-gap requirement of the fabrication process employed to fabricate fixed and movable electrodes 30, 32. By way of example, a minimum gap requirement of an etch process may be 1.5 microns. Accordingly, embodiments described below provide a technique for reducing the effective gap width between fixed and movable electrodes 30, 32 during travel of movable electrodes 32 along drive axis 36 without breaking the design rules of the minimum-gap requirement. Thus, the gap width can be much smaller than the minimum-gap width requirement of the fabrication process.

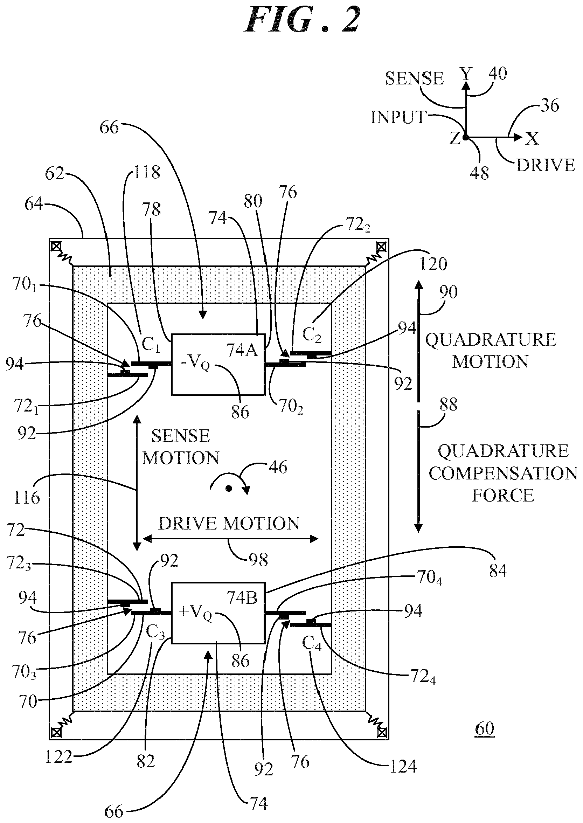

FIG. 2 shows a top view of an angular rate sensor 60 in accordance with an embodiment. In general, angular rate sensor 60 includes a movable mass system 62 flexibly coupled to a substrate 64 and a quadrature compensation unit 66. Quadrature compensation unit 66 includes pairs of fixed and movable electrodes 70, 72. More particularly, fixed electrode 70 of each pair extends from an anchor structure 74 coupled to substrate 64 and movable electrode 72 of each pair is coupled to and extends from movable mass system 62. Thus, movable electrode 72 is movable relative to fixed electrode 70. In the illustrated example, fixed and movable electrodes 70, 72 are lengthwise oriented in a first direction corresponding to drive axis 36.

Additionally, movable electrode 72 is laterally spaced apart from fixed electrode 70 by a first gap, referred to herein as an initial gap 76, in a second direction corresponding to sense axis 40 that is perpendicular to drive axis 36.

Like movable mass system 22, movable mass system 62 is represented in greatly simplified form. It should be understood, however, that movable mass system 62 can include a great variety of shapes, such as circular rings, disks, rectangles, and the like. In addition, movable mass system 62 may include one or more drive masses suitably interconnected with one or more sense masses. Alternatively, movable mass system 22 may include a single mass flexibly coupled to substrate 64. Such variances in structure will still include quadrature compensation electrodes (i.e., pairs of fixed and movable electrodes 70, 72) in association with the drive mass portion of movable mass system 62.

Furthermore, fixed and movable electrodes of a drive system and fixed and movable electrodes of a sense system are not shown in FIG. 2 for simplicity of illustration. It should be further understood that the use of relational terms herein, if any, such as first and second, top and bottom, and the like are used solely to distinguish one from another entity or action without necessarily requiring or implying any actual such relationship or order between such entities or actions.

In this example, quadrature compensation unit 66 includes two anchor structures 74, designated a first anchor structure 74A and a second anchor structure 74B. A pair of fixed and movable electrodes 70, 72 is distinguished by the subscript "1" and thus the electrodes include a first fixed electrode $70_1$ and a first movable electrode $72_1$. Similarly, another pair of fixed and movable electrodes 70, 72 is distinguished by the subscript "2" and thus the electrodes include a second fixed electrode $70_2$ and a second movable electrode $72_2$. Another pair of fixed and movable electrodes 70, 72 is distinguished the subscript "3" and thus the electrodes include a third fixed electrode $70_3$ and a third movable electrode $72_3$. Yet another pair of fixed and movable electrodes 70, 72 is distinguished by the subscript "4" and thus the electrodes include a fourth fixed electrode $70_4$ and a fourth movable electrode $72_4$.

First fixed electrode $70_1$ extends from a first side 78 of first anchor structure 74A and second fixed electrode $70_2$ extends from a second side 80 of first anchor structure 74A, where second side 80 is opposes first side 78. In addition, third fixed electrode $70_3$ extends from a first side 82 of second anchor structure 74B and fourth fixed electrode $70_4$ extends from a second side 84 of second anchor structure 74B, where second side 84 opposes first side. Each of electrodes 70, 72 is lengthwise oriented in a first direction substantially parallel to drive axis 36.

In some embodiments, first anchor structure 74A is designated for application of a quadrature voltage 86 (labeled $-V_Q$) to first and second fixed electrodes $70_1$, $70_2$ and second anchor structure 74B is designated for application of quadrature voltage 86 (labeled $+V_Q$) to third and fourth fixed electrodes $70_3$, $70_4$ in order to provide a time varying quadrature compensation force 88 to null or otherwise compensate for quadrature motion 90 of the sense mass portion of movable mass system 62. Only four pairs of fixed and movable electrodes 70, 72 are shown for simplicity of illustration. It should be understood, however, than any number of pairs of fixed and movable electrodes 70, 72 may be used to provide sufficient quadrature compensation force 88.

In accordance with an embodiment, each fixed electrode 70 includes an extrusion region 92 extending in the second direction substantially parallel to sense axis 40 toward its corresponding movable electrode 72. Additionally, each of movable electrodes 72 includes an extrusion region 94 extending in the second direction substantially parallel to sense axis 40 toward its corresponding fixed electrode 70. Extrusion regions 92, 94 represent material portions of their respective fixed and movable electrodes 70, 72 that are integral with and extend outwardly and laterally from the sides of electrodes 70, 72 toward the adjacent other one of the fixed and movable electrodes 70, 72.

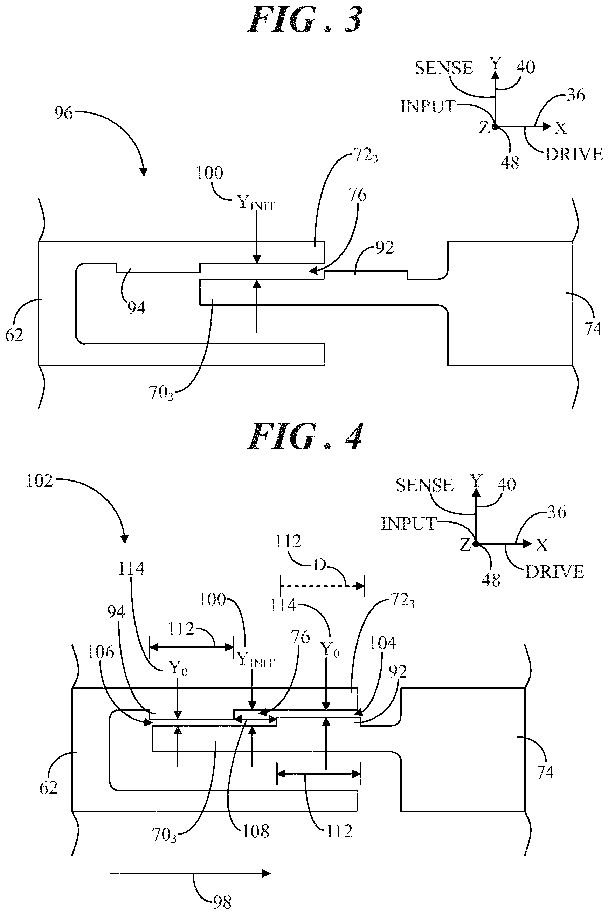

Referring now to FIG. 3 in connection with FIG. 2, FIG. 3 shows an enlarged top view of fixed electrode $70_3$ and movable electrode $72_3$ of angular rate sensor 60 in a first position 96 relative to one another. FIG. 3 represents a condition in which movable electrode $72_3$ is not undergoing oscillatory drive motion 98 (see FIG. 2). Thus, first position 96 represents the location of movable electrode $72_3$ relative to fixed electrode $70_3$ when movable electrode $72_3$ has not yet been driven to oscillate. The enlarged view of FIG. 3, more clearly shows extrusion region 92 extending from fixed electrode $70_3$ toward movable electrode $72_3$ and extrusion region 94 extending from movable electrode $72_3$ toward fixed electrode $70_3$.

The following discussion refers to fixed and movable electrodes $70_3$, $72_3$ for simplicity of illustration. It should be understood, however, that the following discussion applies equivalently to all of fixed and movable electrodes 70, 72 of quadrature compensation unit 66 incorporated in angular rate sensor 60. As will be discussed in significantly greater detail below, the inclusion of extrusion regions 92, 94 provide capacitance enhancement to thereby enable a reduction of the applied quadrature voltage 86 and/or reduction of the overlap area (N) of fixed and movable electrodes 70, 72. I reduction in the overlap area effectively decreases the area needed for quadrature compensation unit 66.

Additionally, or alternatively, in some embodiments the pairs of fixed and movable electrodes that may be implemented within a drive system (not shown) or a sense system (not shown) of angular rate sensor 60 may also include extrusion regions, similar to extrusion regions 92, 94. In such configurations, capacitance enhancement may be achieved in order to minimize the drive actuation voltage and/or to maximize the sensing capacitance.

As shown in FIG. 3, movable electrode $72_3$ is spaced apart from fixed electrode $70_3$ by initial gap 76 in a direction parallel to sense axis 40, that is therefore perpendicular to drive axis 36. Initial gap 76 exhibits a first width, referred to herein as an initial width 100 and labeled $Y_{INIT}$. Initial width 100 is a minimum allowable spacing between fixed and movable electrodes $70_3$, $72_3$ as limited by the fabrication process, such as a deep reactive ion etch (DRIE) process, used to form fixed and movable electrodes $70_3$, $72_3$.

Furthermore, in first position 96, when movable electrode $72_3$ is not undergoing oscillatory drive motion 98, extrusion regions 92, 94 are not positioned between fixed and movable electrodes $70_3$, $72_3$. That is, each of extrusion regions 92, 94 is displaced in the X-direction away from the longitudinal sides of the opposing movable or fixed electrode $72_3$, $70_3$. By fabricating extrusion regions 92, 94, at locations on fixed and movable electrodes $70_3$, $72_3$ that are not directly across from the longitudinal sides of the opposing movable or fixed electrode $72_3$, $70_3$, the minimum requirements for the width of gap 76 are not violated during the fabrication process.

Now referring to FIGs. 2 and 4, FIG. 4 shows an enlarged top view of fixed electrode $70_3$ and movable electrode $72_3$ of angular rate sensor 60 in a second position 102 relative to one another. In operation, movable electrode $72_3$ is configured to undergo oscillatory drive motion 98 with movable mass system 62 such that extrusion regions 92, 94 are periodically positioned between fixed and movable electrodes $70_3$, $72_3$. That is, extrusion region 92 extending from fixed electrode $70_3$ is periodically spaced apart from movable electrode $72_3$ while concurrently, extrusion region 94 extending from movable electrode $72_3$ is spaced apart from fixed electrode $70_3$.

When movable electrode $72_3$ oscillates into second position 102, a second gap 104 is formed between extrusion region 92 and movable electrode $72_3$ and a third gap 106 is formed between extrusion region 94 and fixed electrode $70_3$. However, some amount of spacing 108 may still exist between the adjacent extrusion regions 92, 94 so that extrusion regions 92, 94 do not contact one another. Movable electrode $72_3$ moves a distance 110, labeled D, during a first half period (i.e., one direction of travel) of oscillatory drive motion 98 in accordance with a drive amplitude of oscillatory drive motion 98. In an embodiment, each of extrusion regions 92, 94 exhibits a length 112 in the X-direction, i.e., parallel to drive axis 36 that is at least equivalent to or greater than distance 110.

Each of second and third gaps 104, 106 exhibits a width 114, labeled Yo, that is less than initial width 100. By way of example, width 114 may be approximately half of initial width 100. Thus, if initial width 100 is approximately 1.5 microns and limited by the minimal allowable spacing requirements of the fabrication process, width 114 of 0.8 microns may be achievable. Accordingly, the presence of extrusion regions 92, 94, each of length 112, enables the effective formation of second and third gaps 104, 106 having the narrower width 114 relative to initial width 100. Moreover, this narrower width 114 generally extends along a majority of the adjacent lengths of the quadrature compensation electrodes, i.e., fixed and movable electrodes $70_3$, $72_3$, of quadrature compensation unit 66.

With continued reference to FIGs. 2 and 4, in order to operate angular rate sensor 60, movable electrodes 70 together with movable mass system 62 are actuated to undergo oscillatory drive motion 98 substantially parallel to drive axis 36. Once movable mass system 62 is put into oscillatory drive motion 98, it is capable of detecting angular velocity 46 (see FIG. 2) induced by angular rate sensor 60 being rotated about input axis 48. As angular rate sensor 60 experiences angular velocity 46 about input axis 48, movable mass system 62 undergoes oscillatory sense motion, represented by a bi-directional arrow 116 in FIG. 2, substantially parallel to sense axis 40. In particular, a Coriolis acceleration occurs relative to sense axis 40, which is perpendicular to both drive axis 36 and input axis 48. The Coriolis acceleration causes generally in-plane linear oscillatory sense motion 116 of movable mass system 22 parallel to sense axis 40. This linear oscillatory sense motion 116 has an amplitude that is proportional to angular velocity 46 of sensor 20 about input axis 48. Oscillatory sense motion 116 can be detected as changes in capacitance between fixed and movable sense electrodes of a sense system (not shown for simplicity).

As the sense mass portion of movable mass system 62 undergoes quadrature motion 90 in response to drive motion 98, quadrature compensation unit 66 can apply an electrostatic force, i.e., quadrature compensation force 88, via fixed and movable electrodes 70, 72 in opposite phase relation to quadrature motion 90. Quadrature compensation force 88 is inherently modulated by drive motion 98 due to a relatively high drive amplitude. Furthermore, in accordance with equation (3) above, since width 114 of first and second gaps 104, 106 is significantly less than width 100 of initial gap 76, capacitances 118, 120, 122, 124 (labeled $C_1$, $C_2$, $C_3$, $C_4$ in FIG. 2) between corresponding movable and fixed electrodes 70, 72 can be enhanced from the nominal capacitances of movable and fixed electrodes 30, 32 (FIG. 1) beyond the minimum gap width capabilities of the fabrication process. Thus, quadrature compensation force 88 can compensate for, or otherwise null, quadrature motion 90 using a lower voltage ($V_Q$) and less electrode overlap area (N) than prior art quadrature compensation units..

As in FIG. 1, the arrow representing quadrature compensation force 88 is oriented in a direction opposite to that of the arrow representing quadrature motion 90 in order to emphasize the opposite phase relation. Again, it should be understood that quadrature motion 90 is an oscillatory motion. Therefore, quadrature compensation force 88 is an oscillatory motion in opposite phase relation to the oscillatory quadrature motion 90.

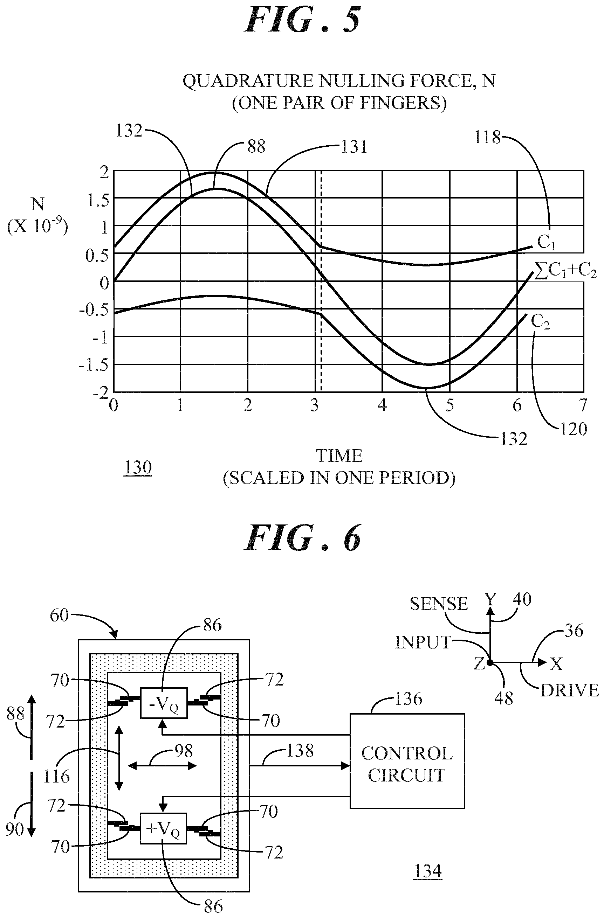

FIG. 5 shows a chart 130 of a time varying quadrature compensation force 88 resulting from the implementation of fixed and movable electrodes 70, 72 (FIG. 2) within angular rate sensor 60 (FIG. 2). As shown in FIG. 5, a first force curve 131 is produced by capacitance 118, labeled $C_1$, between first fixed and movable electrodes $70_1$, $72_1$. Similarly, a second force curve 132 is produced by capacitance 120, labeled $C_2$, between first fixed and movable electrodes $70_2$, $72_2$. Capacitances 118, 120 are produced when a suitable quadrature voltage 86 (FIG. 2) is applied to fixed electrodes $70_1$, $70_2$.

During a first half of a period, i.e., approximately 0-3 in chart 130, first force curve 131 resulting from capacitance 118 shows greater variance than second force curve 132. This is due to the reduced width 114 (FIG. 4) of second and third gaps 104, 106 (FIG. 4) between fixed and movable electrodes $70_1$, $72_1$ during the first half period of drive motion 98 (FIG. 4). Conversely, during a second half period, i.e., approximately 3-6 in chart 130, second force curve 132 shows greater variance resulting from capacitance 120 than first force curve 131. This is again due to the reduced width 114 of second and third gaps 104, 106 between fixed and movable electrodes $70_2$, $72_2$ (FIG. 2) during the second half period of drive motion 98 (FIG. 4).

A summation of first and second force curves 131, 132, corresponding to a summation of capacitances 118, 120, yields a full sine wave 132 in phase with drive motion 98 (FIG. 2). In accordance with equations (3) and (4) above, the magnitude of quadrature compensation force 88 is directly related to the capacitances between the pairs of fixed and movable electrodes 70, 72. The smaller width 114 (FIG. 4) of gaps 104, 106 relative to initial width 100 (FIG. 4), which is limited by the fabrication process, directly yields higher values of capacitances 118, 120 (i.e., capacitance enhancement is achieved). Thus, a higher magnitude of quadrature compensation force 88 can be produced corresponding to the higher values of capacitances 118, 120. Accordingly, the peak of each half period of sine wave 132 is the maximum quadrature compensation force 88 for two pairs of fixed and movable electrodes (i.e., first fixed and movable electrodes $70_1$, $72_1$ and second fixed and movable electrodes $70_2$, $72_2$) that can be applied to the sense mass portion of movable mass system 62 (FIG. 2) to null or otherwise compensate for quadrature motion 90. In some embodiments, this maximum quadrature compensation force 88 may be at least three and a half times greater than quadrature compensation force 54 (FIG. 1) of prior art designs that do not include extrusion regions 92, 94 (FIG. 2). As such, with the inclusion of the capacitance enhancement capability, quadrature voltage 86 (FIG. 2) and/or the area taken by the quadrature compensation electrodes (e.g., electrodes 70, 72) can be reduced relative to prior art configurations.

FIG. 6 shows a generalized block diagram of a MEMS device in the form of a sensor package 134 that includes angular rate sensor 60 in electrical communication with a control circuit 136, which may be an application specific integrated circuit (ASIC). More particularly, control circuit 136 may be adapted to receive an output signal 138, a portion of which includes a quadrature motion signal component. In some embodiments, control circuit 136 may be adapted to determine a magnitude of quadrature motion 90 imposed on sense axis 40 from oscillatory drive motion 98 applied to drive axis 36. Control circuit 136 may then apply a corrective voltage, i.e., quadrature voltage 86, to fixed electrodes 70 in order to generate quadrature compensation force 88 that is sufficient to null or otherwise compensate for quadrature motion 90.

Embodiments described herein comprise microelectromechanical systems (MEMS) devices, such as angular rate sensors, in which a quadrature compensation unit is implemented to null or otherwise compensate for quadrature motion. An embodiment of a MEMS device for capacitance enhancement includes a fixed electrode coupled to a substrate and lengthwise oriented in a first direction, a movable electrode coupled to and extending from a movable mass system, the movable electrode being lengthwise oriented in the first direction, the movable electrode being spaced apart from the fixed electrode by a gap in a second direction that is perpendicular to the first direction, and an extrusion region extending in the second direction from one of the fixed and movable electrodes toward the other of the fixed and movable electrodes.

Another embodiment of a MEMS device includes a mass system flexibly coupled to a substrate, the mass system being configured to undergo oscillatory drive motion relative to a drive axis and the mass system being further configured to undergo oscillatory sense motion relative to a sense axis that is perpendicular to the drive axis in response to an angular velocity about an input axis that is perpendicular to each of the drive and sense axes. The MEMS device further includes a quadrature correction unit in which the quadrature correction unit includes a fixed electrode coupled to the substrate and lengthwise oriented in a first direction that is substantially parallel to the drive axis and a movable electrode coupled to and extending from the mass system, the movable electrode being lengthwise oriented in the first direction, and the movable electrode being spaced apart from the fixed electrode in a second direction parallel to the sense axis by a first gap exhibiting a first width. A first extrusion region extends in the second direction from the fixed electrode toward the movable electrode and a second extrusion region extends in the second direction from the movable electrode toward the fixed electrode. The movable electrode is configured to undergo the oscillatory drive motion with the mass system such that the first extrusion region is periodically spaced apart from the movable electrode by a second gap exhibiting a second width and the second extrusion region is periodically spaced apart from the fixed electrode by a third gap exhibiting the second width, the second width being less than the first width.

The quadrature compensation unit having pairs of fixed and movable electrodes, in which the fixed and movable electrodes include extrusion regions extending toward one another is implemented to null or otherwise compensate for quadrature motion. When the movable electrodes undergo oscillatory motion, the extrusion regions are periodically positioned between each pair of fixed and movable electrodes to effectively reduce a width of a gap between the movable and fixed electrodes. The reduced width of the gap provides capacitance enhancement so as to reduce the voltage and the number of fixed and movable electrodes needed to effectively generate the quadrature compensation force.

Another embodiment of a MEMS device includes a mass system flexibly coupled to a substrate and a quadrature correction unit. The mass system is configured to undergo oscillatory drive motion relative to a drive axis. The mass system is further configured to undergo oscillatory sense motion relative to a sense axis that is perpendicular to the drive axis in response to an angular velocity about an input axis that is perpendicular to each of the drive and sense axes. The quadrature correction unit includes a fixed electrode, a movable electrode, a first extrusion region, a second extrusion region. The fixed electrode is coupled to the substrate and is lengthwise oriented in a first direction that is substantially parallel to the drive axis. The movable electrode is coupled to and extends from the mass system. The movable electrode is lengthwise oriented in the first direction. The movable electrode is spaced apart from the fixed electrode in a second direction parallel to the sense axis by a first gap exhibiting a first width. The first extrusion region extends in the second direction from the fixed electrode toward the movable electrode. The second extrusion region extends in the second direction from the movable electrode toward the fixed electrode. The movable electrode is configured to undergo the oscillatory drive motion with the mass system such that the first extrusion region is periodically spaced apart from the movable electrode by a second gap exhibiting a second width. The second extrusion region is periodically spaced apart from the fixed electrode by a third gap exhibiting the second width. The second width is less than the first width.

In an example, the first width is a minimum allowable spacing between the fixed and movable electrodes limited by a fabrication process used to form the fixed and movable electrodes. The second width is less than the minimum allowable spacing.

In an example, when the movable electrode is not undergoing the oscillatory drive motion, neither of the first and second extrusion regions are positioned between the fixed and movable electrodes.

In an example, the movable electrode moves a distance during a first half period of the oscillatory drive motion in accordance with a drive amplitude of the oscillatory drive motion. Each of the first and second extrusion regions exhibits a length in the first direction that is greater than the distance.

In an example, the first and extrusion regions are periodically positioned between the fixed and movable electrodes concurrently without contacting one another.

In an example, the second width is approximately one half of the first width.

This disclosure is intended to explain how to fashion and use various embodiments in accordance with the invention rather than to limit the true, intended, and fair scope and spirit thereof. The foregoing description is not intended to be exhaustive or to limit the invention to the precise form disclosed. Modifications or variations are possible in light of the above teachings. The embodiment(s) was chosen and described to provide the best illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims, as may be amended during the pendency of this application for patent, and all equivalents thereof, when interpreted in accordance with the breadth to which they are fairly, legally, and equitably entitled.

## Claims

1. A MEMS device for capacitance enhancement comprising:

   a fixed electrode (70) coupled to a substrate (24, 64) and lengthwise oriented in a first direction (36);
   a movable electrode (72) coupled to and extending from a movable mass system (62), said movable electrode being lengthwise oriented in said first direction, said movable electrode being spaced apart from said fixed electrode by a gap (76) in a second direction (40) that is perpendicular to said first direction; and
   an extrusion region (94) extending in said second direction from one of said fixed and movable electrodes toward the other of said fixed and movable electrodes.

2. The MEMS device of claim 1, wherein:

said gap between said fixed and movable electrodes is a first gap exhibiting a first width (100); and

said movable electrode is configured to undergo oscillatory motion with said mass system such that said extrusion region is periodically spaced apart from the other of said fixed and movable electrodes by a second gap (104) exhibiting a second width (114), said second width being less than said first width.

3. The MEMS device of claim 2, wherein:

said first width is a minimum allowable spacing between said fixed and movable electrodes limited by a fabrication process used to form said fixed and movable electrodes; and
said second width is less than said minimum allowable spacing.

4. The MEMS device of claim 2 or claim 3, wherein when said movable electrode is not undergoing said oscillatory drive motion (98), said extrusion region is not positioned between said fixed and movable electrodes.

5. The MEMS device of any one of the claims 2 to 4, wherein said movable electrode moves a distance (110) during a first half period of said oscillatory motion in accordance with an amplitude of said oscillatory motion, and said extrusion region exhibits a length (112) in said first direction that is greater than said distance.

6. The MEMS device of any one of the claims 2 to 5, wherein said second width is approximately one half of said first width.

7. The MEMS device of any one of the claims 1 to 6, wherein said extrusion region is a first extrusion region (92) extending from said fixed electrode toward said movable electrode, and said angular rate sensor further comprises a second extrusion region (94) extending in said second direction from said movable electrode toward said fixed electrode.

8. The MEMS device of claim 7, wherein said movable electrode is configured to undergo said oscillatory motion with said movable mass system such that said first and second extrusion regions are periodically positioned between said fixed and movable electrodes.

9. The MEMS device of claim 7 or claim 8, wherein said first and extrusion regions are periodically positioned between said fixed and movable electrodes concurrently without contacting one another.

10. The MEMS device of claim 8 or claim 9, wherein:

said gap between said fixed and movable electrodes is a first gap exhibiting a first width; and when said first and second extrusion regions are positioned between said fixed and movable electrodes, said first extrusion region is spaced apart from said movable electrode by a second gap and said second extrusion region is spaced apart from said fixed electrode by a third gap, each of said second and third gaps exhibiting a second width, said second width being less than said first width.

11. The MEMS device of any one of the claims 1 to 10, wherein said fixed electrode is a first fixed electrode (701), said movable electrode is a first movable electrode (721), said extrusion region is a first extrusion region (92), said gap is a first gap (76), said first fixed electrode extends from a first side (78) of an anchor structure (74) coupled to said substrate, and said MEMS device further comprises:

a second fixed electrode (702) extending from a second side (84) of said anchor structure and lengthwise oriented in said first direction, said second side opposing said first side;
a second movable electrode (722) coupled to and extending from said movable mass system, said second movable electrode being lengthwise oriented in said first direction, said second movable electrode being spaced apart from said second fixed electrode in said second direction by said first gap, said first gap exhibiting a first width (100); and
a second extrusion region (94) extending in said second direction from one of said second fixed and second movable electrodes toward the other of said second fixed and second movable electrodes, wherein said first and second movable electrodes are configured to undergo oscillatory drive motion in phase opposition such that said first extrusion region is periodically spaced apart from the other of said first fixed and said first movable electrodes by a second gap (104) exhibiting a second width (114), and said second extrusion region is periodically spaced apart from the other of said second fixed and second movable electrodes by a third gap (106) exhibiting said second width, said second width being less than said first width.

12. The MEMS device of any one of the claims 1 to 11, wherein:

said movable mass system is flexibly coupled to a substrate (24, 64), said movable mass system being configured to undergo oscillatory drive motion (98) relative to a drive axis (36) that is substantially parallel to said first direction and said mass system being further configured to undergo oscillatory sense motion relative to a sense axis (40) that is substantially parallel to said second direction in response to an angular velocity (46) about an input axis (48) that is perpendicular to each of said drive and sense axes; and

said MEMS device further comprises a control circuit (136) in electrical communication with said fixed electrode, said control circuit determining a magnitude of quadrature motion (52, 90) of said mass system in said second direction along said sense axis from said oscillatory drive motion in said first direction, and applying a corrective voltage to said fixed electrode to compensate for said quadrature motion.

13. A MEMS device comprising:

a mass system flexibly coupled to a substrate (24, 64), said mass system being configured to undergo oscillatory drive motion relative to a drive axis (36) and said mass system being further configured to undergo oscillatory sense motion relative to a sense axis (40) that is perpendicular to said drive axis in response to an angular velocity (46) about an input axis (48) that is perpendicular to each of said drive and sense axes; and
a quadrature correction unit according to the MEMS device for capacitance enhancement of any one of the claims 1 to 12,

wherein the first direction is substantially parallel to the drive axis and the second direction is substantially parallel to said sense axis.

14. An angular rate sensor comprising:

a mass system flexibly coupled to a substrate (24, 64), said mass system being configured to undergo oscillatory drive motion (98) relative to a drive axis (36) and said mass system being further configured to undergo oscillatory sense motion relative to a sense axis (40) that is perpendicular to said drive axis in response to an angular velocity (46) about an input axis (48) that is perpendicular to each of said drive and sense axes; and
a quadrature correction unit including:

a fixed electrode (70) coupled to said substrate and lengthwise oriented in a first direction that is substantially parallel to said drive axis;
a movable electrode (72) coupled to and extending from said mass system, said movable electrode being lengthwise oriented in said first direction, said movable electrode being spaced apart from said fixed electrode in a second direction parallel to said sense axis by a first gap (76) exhibiting a first width (100); and
an extrusion region (94) extending in said second direction from one of said fixed and movable electrodes toward the other of said fixed and movable electrodes, wherein:

said extrusion region is not positioned between said movable electrodes when said mass system is not undergoing said oscillatory drive motion;
said movable electrode is configured to undergo said oscillatory drive motion with said mass system such that said extrusion region is periodically spaced apart from the other of said fixed and movable electrodes by a second gap (104) exhibiting a second width (114), said second width being less than said first width;
said movable electrode moves a distance (110) during a first half period of said oscillatory drive motion in accordance with a drive amplitude of said oscillatory drive motion; and
said extrusion region exhibits a length in said first direction that is greater than said distance.

15. The angular rate sensor of claim 14, wherein:

said first width is a minimum allowable spacing between said fixed and movable electrodes limited by a fabrication process used to form said fixed and movable electrodes; and

said second width is less than said minimum allowable spacing.

# FIG . 1

SENSE Y 40
INPUT X 36
Z DRIVE
48

26
22
24 38 32

52
QUADRATURE
MOTION

30
34
38 -V_Q
32 30

SENSE
MOTION

54
QUADRATURE
COMPENSATION
FORCE

50
46
DRIVE MOTION
44

32
34
38 +V_Q
30 30

$Y_0$
42

32

38

20

26

PRIOR ART

# FIG . 2

# FIG . 3

# FIG . 4

## FIG. 5

QUADRATURE NULLING FORCE, N
(ONE PAIR OF FINGERS)

130

TIME
(SCALED IN ONE PERIOD)

## FIG. 6

Europäisches
Patentamt

European
Patent Office

Office européen
des brevets

## PARTIAL EUROPEAN SEARCH REPORT

under Rule 62a and/or 63 of the European Patent Convention.
This report shall be considered, for the purposes of
subsequent proceedings, as the European search report

Application Number

EP 16 19 8839

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/320591 A1 (JOHNSON BURGESS R [US]) 31 December 2009 (2009-12-31) * paragraphs [0019], [0032] - [0036], [0056] - [0070]; figure 6 * ----- | 1-13 | INV. G01C19/5733 B81B5/00 G01P15/125 |
| X | US 2014/152325 A1 (NARITA KATSUTOSHI [JP]) 5 June 2014 (2014-06-05) * paragraphs [0055] - [0060]; figure 2 * ----- | 1 | |

TECHNICAL FIELDS
SEARCHED      (IPC)

G01C
B81B
G01P

## INCOMPLETE SEARCH

The Search Division considers that the present application, or one or more of its claims, does/do
not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| The Hague | 18 May 2017 | Rocca, Simone |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

             

& : member of the same patent family, corresponding
    document

EPO FORM 1503 03.82 (P04E07)

Europäisches
Patentamt

European
Patent Office

Office européen
des brevets

**INCOMPLETE SEARCH**
**SHEET C**

Application Number

EP 16 19 8839

Claim(s) completely searchable:
        1-13

Claim(s) not searched:
        14, 15

Reason for the limitation of the search:

The search has been carried out on the basis of claims 1-13, as indicated by the applicant in the communication dated 15-05-2017, following the invitation pursuant Rule 62a(1) EPC.

## ANNEX TO THE EUROPEAN SEARCH REPORT
## ON EUROPEAN PATENT APPLICATION NO.

EP 16 19 8839

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2017

| Patent document cited in search report | | | Publication date | Patent family member(s) | | | Publication date |
|---|---|---|---|---|---|---|---|
| US 2009320591 | A1 | | 31-12-2009 | EP | 2071284 | A2 | 17-06-2009 |
| | | | | JP | 5349891 | B2 | 20-11-2013 |
| | | | | JP | 2009271052 | A | 19-11-2009 |
| | | | | US | 2009320591 | A1 | 31-12-2009 |
| US 2014152325 | A1 | | 05-06-2014 | CN | 103717997 | A | 09-04-2014 |
| | | | | EP | 2743639 | A1 | 18-06-2014 |
| | | | | US | 2014152325 | A1 | 05-06-2014 |
| | | | | WO | 2013021467 | A1 | 14-02-2013 |

EPO FORM P0459

For more details about this annex : see Official Journal of the European Patent Office, No. 12/82